# FASCICULE DE BREVET EUROPEEN

(11) **EP 2 823 323 B1**
(45) Date de publication et mention de la délivrance du brevet: **24.02.2016**
(21) Numéro de dépôt: 13707406.8
(22) Date de dépôt: 06.03.2013
(51) Int. Cl.: G01R 31/12, G01R 31/02

(54) **PROCEDE DE RECONNAISSANCE DE DECHARGES PARTIELLES EMISES A L'INTERIEUR OU A L'EXTERIEUR D'UN APPAREIL ELECTRIQUE**
VERFAHREN ZUR ERKENNUNG VON INNERHALB ODER AUSSERHALB EINER ELEKTRISCHEN VORRICHTUNG EMITTIERTEN TEILENTLADUNGEN
METHOD FOR RECOGNISING PARTIAL DISCHARGES EMITTED INSIDE OR OUTSIDE AN ELECTRICAL APPARATUS

(30) Priorité: 09.03.2012 FR 1252152
(43) Date de publication de la demande: 14.01.2015
(73) Titulaire: ALSTOM Technology Ltd, 5400 Baden (CH)
(72) Inventeur: DAOUDI, Bouchra, F-78130 Les Mureaux (FR); LEBRETON, Raphaël, 91300 MASSY (FR); LOUISE, Sébastien, F-94600 Choisy le Roi (FR); LUNA, Gilbert, F-93420 Villepinte (FR)
(74) Mandataire: Brevalex
(86) Numéro de dépôt international: PCT/EP2013/054489
(87) Numéro de publication internationale: WO 2013/131948

(56) Documents cités:
- EP-A2- 1 439 396
- WO-A1-2011/051910
- US-A1- 2009 119 035
- MONTANARI G C ET AL: "A new approach to partial discharge testing of HV cable systems", IEEE ELECTRICAL INSULATION MAGAZINE, IEEE SERVICE CENTER, NEW YORK, NY, US, vol. 11, no. 1, 1 janvier 2006 (2006-01-01), pages 14-23, XP011265230, ISSN: 0883-7554
- CAVALLINI A ET AL: "A new approach to the diagnosis of solid insulation systems based on PD signal inference", IEEE ELECTRICAL INSULATION MAGAZINE, IEEE SERVICE CENTER, NEW YORK, NY, US, vol. 11, no. 2, 1 mars 2003 (2003-03-01), pages 23-30, XP011264889, ISSN: 0883-7554
- STRACHAN S M ET AL: "Knowledge-based diagnosis of partial discharges in power transformers", IEEE TRANSACTIONS ON DIELECTRICS AND ELECTRICAL INSULATION, IEEE SERVICE CENTER, PISCATAWAY, NJ, US, vol. 15, no. 1, 1 février 2008 (2008-02-01), pages 259-268, XP011200964, ISSN: 1070-9878, DOI: 10.1109/T-DEI.2008.4446759
- BORGHETTO J ET AL: "Partial Discharge Inference by an Advanced System. Analysis of Online Measurements Performed on Hydrogenerator", IEEE TRANSACTIONS ON ENERGY CONVERSION, IEEE SERVICE CENTER, PISCATAWAY, NJ, US, vol. 19, no. 2, 1 juin 2004 (2004-06-01), pages 333-339, XP011113368, ISSN: 0885-8969, DOI: 10.1109/TEC.2004.827473
- N.C. SAHOO ET AL: "Trends in partial discharge pattern classification: a survey", IEEE TRANSACTIONS ON DIELECTRICS AND ELECTRICAL INSULATION, vol. 12, no. 2, 1 avril 2005 (2005-04-01), pages 248-264, XP055045624, ISSN: 1070-9878, DOI: 10.1109/TDEI.2005.1430395
- A. CONTIN ET AL: "Digital detection and fuzzy classification of partial discharge signals", IEEE TRANSACTIONS ON DIELECTRICS AND ELECTRICAL INSULATION, vol. 9, no. 3, 1 juin 2002 (2002-06-01), pages 335-348, XP055045619, ISSN: 1070-9878, DOI: 10.1109/TDEI.2002.1007695

## Description

### DOMAINE TECHNIQUE

L'invention concerne un procédé de reconnaissance de décharges partielles émises à l'intérieur et à l'extérieur d'un appareil électrique. L'invention se rapporte à une reconnaissance d'images adaptée aux formes obtenues lors de la mesure de décharges partielles dans un appareil électrique ou en son voisinage.

### ÉTAT DE LA TECHNIQUE ANTÉRIEURE

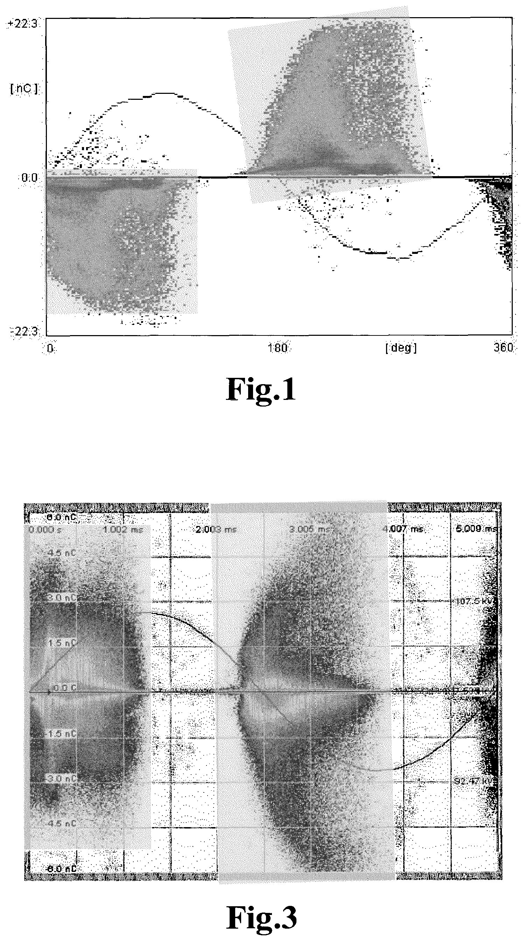

Les appareils électriques dont l'isolation, air, huile, ou papier..., est défaillante produisent des décharges partielles qui peuvent détériorer l'isolation jusqu'à ce que cette isolation perde complètement ses propriétés isolantes et devienne conductrice. On assiste alors à un phénomène de claquage, qui peut entrainer la destruction au moins partielle de ces appareils. La mesure des décharges partielles selon la norme CEI 60 270 permet de prévenir ce phénomène de claquage, d'analyser les décharges dans les appareils, de diagnostiquer un défaut et donc de surveiller et protéger les appareils électriques. De cette protection peut dépendre la fourniture d'électricité à une usine, à une ville ou à des régions entières. Chaque défaut a sa propre forme de décharges partielles avec une tension d'apparition et de disparition, une évolution dans le temps... Cependant, même si chaque forme de décharges est différente, on peut observer des tendances similaires en fonction du défaut qui provoque les décharges. Par exemple, un défaut du à une mauvaise imprégnation des isolants ou à un mauvais séchage des isolants crée une forme de décharges du type de celle illustrée sur la figure 1, même si la phase (en fonction de celle sur laquelle la mesure est connectée), l'amplitude, et la forme elle-même peuvent changer. La reconnaissance d'une forme de décharges partielles permet d'identifier un défaut et en même temps, de savoir quelles mesures correctives prendre pour le supprimer. La reconnaissance de telles décharges partielles est aujourd'hui un travail d'experts, or, pour des raisons évidentes de coûts et de délais chaque usine qui met au point des appareils électriques utilisant une isolation solide ou liquide doit pouvoir diagnostiquer rapidement la cause de décharges partielles, si elle en rencontre.

La reconnaissance de telles décharges partielles est critique pour les constructeurs de gros appareils électriques industriels (moteurs, transformateurs, postes à isolation gazeuse (GIS) haute et moyenne tension...).

Les décharges partielles dans les appareils électriques haute tension, tels que les gros transformateurs de puissance, sont associées à l'émission d'ondes hautes fréquences ou ultra hautes fréquences et d'ondes acoustiques (généralement ultrasonores) qui se propagent dans le fluide acoustiquement conducteur. Il est ainsi possible de détecter et de chercher à localiser ces sources de décharges partielles à l'aide de détecteurs acoustiques associés éventuellement avec des moyens de détection électriques des ondes hautes fréquences ou ultra hautes fréquences.

La reconnaissante d'image est assez répandue mais aucune n'est adaptée aux décharges partielles.

Un système de reconnaissance de forme est décrit dans le brevet US 5,703,564. Ce système utilise une classification statistique. Mais ce système ne décrit pas une reconnaissance d'images adaptée aux formes obtenues lors de la mesure de décharges partielles.

Plusieurs documents de l'art antérieur sont analysés ci-dessous.

US 2009/0119035 décrit un procédé et un appareil pour analyser des décharges partielles dans des dispositifs électriques.

US 2004/0204873 décrit un procédé et un appareil pour l'analyse et la surveillance du comportement d'un dispositif électrique en présence de décharges partielles.

WO 2011/051910 décrit un dispositif et un procédé pour détecter et traiter des signaux relatif à des décharges électriques partielles.

L'article intitulé « A new approach to partial discharge testing of HV cable system » de G.C. Montanari, A. Cavallini et F. Suletti (IEEE Electrical Insulation Magazine, pages 14 à 23, Janvier-Février 2006) décrit une nouvelle approche pour un test de décharge partielle de systèmes de cables haute tension.

L'invention a pour objet de faciliter le diagnostic d'un défaut intérieur ou extérieur à un appareil électrique par l'utilisation de l'image en phase, ou forme, des décharges partielles, en assimilant facilement et automatiquement une forme de décharge à une autre dans une base de données. L'invention permet ainsi, lorsqu'une forme de décharge partielle a été obtenue, de corréler cette forme aux autres formes de décharges partielles stockées dans la base de données et d'obtenir des informations sur le défaut si celui-ci a déjà été rencontré et traité.

### EXPOSÉ DE L'INVENTION

L'invention concerne un procédé de reconnaissance de décharges partielles émises à l'intérieur ou à l'extérieur d'un appareil électrique, selon la revendication 1.

Avantageusement le procédé de l'invention comprend une étape de correction automatique du réglage de traitement de la nouvelle forme de décharges partielles, une étape d'uniformisation de la surface de la nouvelle forme de décharges partielles, une étape de classement de la nouvelle forme de décharges partielles dans une parmi différentes catégories, en divisant la nouvelle forme de décharges partielles en différentes zones, par exemple en quatre parties égales, avec une division en deux horizontale et une division en deux verticale.

Avantageusement, lors de l'étape de comparaison, on réalise un calcul du pourcentage de correspondance entre la nouvelle forme de décharges partielles et les formes déjà enregistrée dans la base de données et un classement selon des pourcentages décroissants.

Avantageusement, le procédé de l'invention comprend les étapes suivantes :
- entrée d'une image couleur correspondant à la nouvelle forme de ces décharges partielles,
- traitement et transposition de l'image couleur en image noir et blanc,
- test d'existence d'une image restante :
   - s'il ne reste pas d'image restante :
- ajustement des paramètres de traitement de l'image couleur et retour en entrée de la première étape,
   - s'il reste des images restantes :
- vérification pour savoir si la taille de la forme de décharges partielles est significative :
   - si taille non significative :
- dilatation dans l'axe des ordonnées de la forme de ces décharges partielles,
   - si taille significative :
- division de la forme de décharge partielle en plusieurs zones d'intérêt, par exemple quatre,
- analyse de ces zones d'intérêt pour classer la forme de décharges partielles,
- comparaison de la forme de décharges partielles à des décharges correspondantes dans la base de données,
- liste des formes de décharges partielles correspondantes,
- diagnostic de la source de ces décharges partielles,
- Si le diagnostic indique une source de décharges intérieures alors examen de l'appareil électrique pour réparer celui-ci et corréler le diagnostic,
- enregistrement dans la base de données des résultats ainsi obtenus.

Avantageusement, l'invention propose une reconnaissance de formes adaptée aux formes de décharges partielles, pour lesquelles il n'existe actuellement aucun outil sur le marché. L'invention permet de faire un tri très performant dans la base de données entre différentes formes de décharges partielles enregistrées en usine, laboratoire ou sur site. Ce tri aide l'utilisateur à diagnostiquer le défaut à l'origine de cette activité de décharges partielles dans un temps beaucoup plus court que s'il devait chercher manuellement une correspondance dans la base de données.

### BRÈVE DESCRIPTION DES DESSINS

La figure 1 illustre une forme de décharges partielles.
La figure 2 est un organigramme illustrant le fonctionnement global du procédé de l'invention.
Les figures 3 à 5 illustrent différentes formes de décharges partielles.
Les figures 6a et 6b illustrent la comparaison de deux formes de décharges partielles.

### EXPOSÉ DÉTAILLÉ DE MODES DE RÉALISATION PARTICULIERS

Les décharges partielles sont très difficiles à reconnaître du fait de leur caractère très sensible aux facteurs électriques environnants, les formes de ces décharges (ou «patterns») dépendent des capacitances, inductances, impédances etc. qui composent un appareil électrique dans lequel ces décharges partielles peuvent apparaitre. Ces appareils étant tous différents, les formes de décharges partielles sont toujours toutes différentes. L'aspect global d'une forme de décharges partielles est défini par le type de défaut qui crée cette activité de décharges. Si l'on est capable de reconnaitre une forme de décharges partielles, et que ce type de forme de décharges partielles est connu, on peut identifier le défaut qui l'a généré et fournir un diagnostic. L'invention propose donc d'utiliser une base de données comprenant un maximum de formes de décharges partielles connues et d'essayer d'identifier une nouvelle forme de décharges partielles à une forme de décharges partielles connues. Si on peut assimiler une nouvelle forme de décharges partielles à une forme de décharges partielles connues, le défaut est identifié.

Avantageusement, on classe, au préalable, les formes de décharges partielles en différentes catégories afin de réduire les risques d'erreur lors de l'identification d'une forme de décharges partielles. Ces catégories facilement identifiables permettent d'améliorer la reconnaissance des décharges partielles dans les catégories sélectionnées. Une fois ce classement spécifique obtenu, on peut utiliser n'importe quel procédé de reconnaissance d'image pour corréler une nouvelle forme de décharges partielles aux formes de décharges partielles d'une catégorie correspondante.

L'invention permet d'assister et d'automatiser la reconnaissance de décharges partielles pour des experts et des non-experts. Lorsqu'une nouvelle forme de décharges partielles est rencontrée, l'invention peut permettre de l'assimiler à une forme de décharges partielles déjà rencontrée et diagnostiquée en se basant sur des problèmes déjà résolus et stockés dans une base de données par exemple. Le procédé de l'invention est évolutif, et se fonde sur une base de données qu'il enrichit au fur et à mesure des investigations.

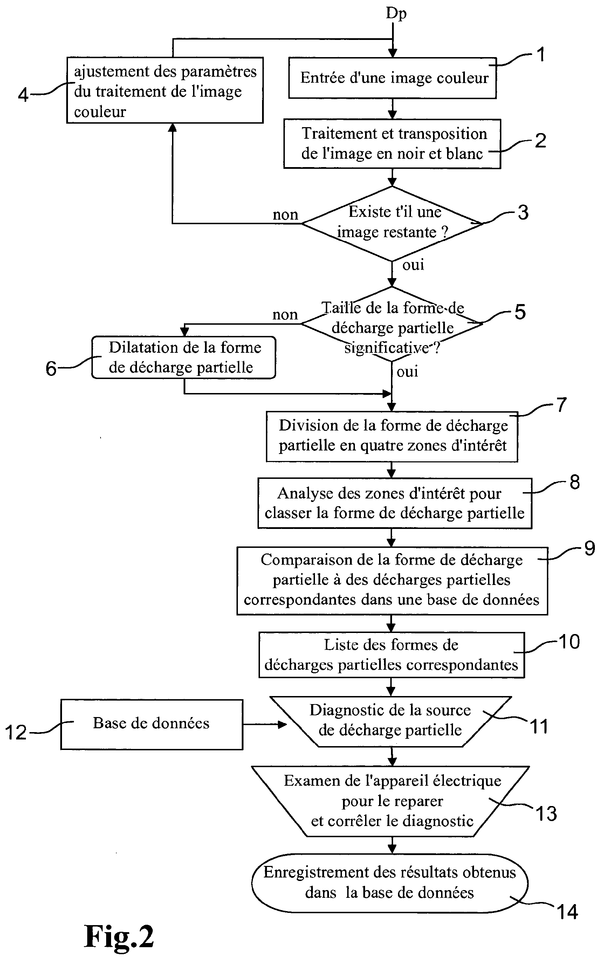

Le fonctionnement global du procédé de l'invention est décrit sur l'organigramme de la figure 2. Cet organigramme, après détection d'au moins une décharge partielle Dp, comprend les étapes suivantes :
- entrée d'une image couleur (1) correspondant à la nouvelle forme de ces décharges partielles,
- traitement et transposition de l'image couleur en image noir et blanc (2),
- test d'existence d'une image restante (3),
   - s'il ne reste pas d'image restante :
- ajustement des paramètres de traitement de l'image couleur et retour en entrée de la première étape (1),
   - s'il reste des images restantes :
- vérification pour savoir si la taille de la forme de décharges partielles est significative (4) :
   - si taille non significative :
- dilatation dans l'axe des ordonnées de la forme de ces décharges partielles (6),
   - si taille significative :
- division de la forme de décharges partielles en plusieurs zones d'intérêt (7), par exemple quatre,
- analyse de ces zones d'intérêt pour classer la forme de décharges partielles (8),
- comparaison de la forme de décharges partielles à des décharges partielles correspondantes dans une base de données(9),
- liste des formes de décharges partielles correspondantes (10),
- diagnostic de la source de décharge partielle (11), grâce à la base de données (12),
- si le diagnostic indique une source de décharges intérieures alors examen de l'appareil électrique pour réparer celui-ci (13) et corréler le diagnostic,
- enregistrement dans la base de données des nouveaux résultats ainsi obtenus (14).

Cet organigramme commence par l'acquisition d'une nouvelle forme de décharges partielles ayant l'aspect d'une image couleur (par exemple la forme de décharges de la figure 1). Cette nouvelle forme de décharges partielles, dans un appareil électrique ou à l'extérieur, correspond à un défaut qu'il faut diagnostiquer pour pouvoir le réparer ou le traiter sans réparation si cela est possible. Une telle réparation engendrant des retards et des coûts importants, il est essentiel de pouvoir s'affranchir de tout diagnostic erroné. Une forme de décharges partielles est le relevé d'une série de décharges partielles mesurée en phase avec une tension d'essai. Chaque point de cette forme correspond à une amplitude (ou magnitude) de la décharge mesurée en coulombs (C) à un instant donné (phase mesurée en degrés, de 0 à 360°) de la sinusoïde qui alimente l'appareil électrique.

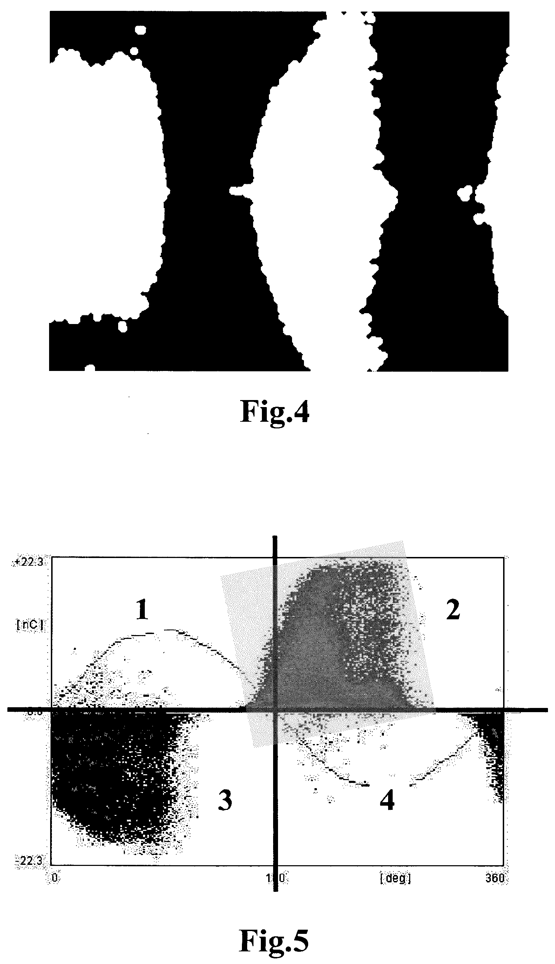

L'image couleur est ensuite traitée et transposée en image noir et blanc (étape 2). Cette étape est nécessaire pour exploiter les images provenant des différents appareils de mesure de décharges partielles qui n'utilisent pas forcément la même couleur pour afficher les décharges. La figure 3 représente ainsi une mesure de décharge avec un appareil différent de celui utilisé pour la figure 1. Le résultat du passage en noir et blanc est illustré sur la figure 4.

L'étape 3 consiste à vérifier qu'une forme de décharges partielles est toujours présente. Par exemple si la mesure de décharges a été trop rapide, il n'y avait peut-être pas assez de concentration de points et ils ont été perdus lors du traitement. S'il s'avère que la forme de décharges était effectivement peu marquée et qu'elle a été perdue, le procédé de l'invention corrige automatiquement ses données de traitement pour réaliser un réglage plus fin et pour essayer de conserver un maximum de points. Cependant, certains enregistrements de décharges qui ne contiennent que quelques points éparses, ne peuvent être utilisés.

L'étape 5 permet d'uniformiser la surface des formes de décharges partielles. Pour une meilleure reconnaissance des formes de décharges, il est recommandé qu'elles occupent le même volume d'espace dans l'image. Une forme de décharges partielles très plate est difficilement reconnaissable. L'étape 5 consiste à dilater la forme de décharges de la même manière que l'aurait fait un zoom sur l'axe des ordonnées, ou une augmentation du gain de mesure. Si la forme de décharges occupe par exemple moins du tiers de l'espace en amplitude (échelle verticale) alors la forme de décharges partielles est dilatée.

L'étape 7 consiste à diviser la forme de décharges partielles en quatre parties égales, une division en deux horizontale et une division en deux verticale. Les quatre zones obtenues sont numérotées de 1 à 4, comme illustré sur la figure 5. Cette division permet ensuite de classer la forme de décharges partielles dans l'une des catégories suivantes : 0, 1, 2, 3 ou 4. Dans le cas d'un montage indirect de mesure (sonde de mesure mise en parallèle avec appareil), la catégorie 1 regroupe les formes de décharges partielles ayant principalement leurs décharges partielles dans les zones 2 et 3, la catégorie 2 les formes de décharges partielles ayant principalement leurs décharges partielles dans les zones 1 et 4, la catégorie 3 les formes de décharges partielles ayant principalement leurs décharges partielles dans les zones 1 et 3 ou 2 et 4 ou le cas où une seule zone regroupe la majorité des décharges partielles, la catégorie 4 le cas où les quatre zones ont une quantité équivalente de décharges partielles et la catégorie 0 les formes de décharges partielles qui ne rentrent dans aucune autre catégorie.

L'étape 9 consiste à comparer cette nouvelle forme de décharge à des formes de décharges partielles existantes dans une base de données. Cette base de données regroupe toutes les formes de décharges partielles déjà enregistrées et le diagnostic associé si un défaut a pu être corrélé à la forme de décharges partielles. La comparaison de cette nouvelle forme de décharges partielles aux formes de décharges partielles de la base de données permet de trouver des défauts identiques déjà diagnostiqués, dont les techniques de réparation sont connues et éprouvées. Pour la comparaison et afin d'avoir les résultats les meilleurs possible, le procédé de l'invention consiste à s'appuyer sur une catégorie assignée à la forme de décharge et, en fonction de cette catégorie, de comparer cette forme de décharges partielles aux formes de décharges de la base de données appartenant aux mêmes catégories, suivant le tableau ci-dessous :

| Catégorie de la forme de décharge partielle à comparer | Catégories des formes de décharges partielles de la base de données (en comparaison) |
|---|---|
| 0 | 0 - 1 - 4 |
| 1 | 0 - 1 - 4 |
| 2 | 2 |
| 3 | 0 - 3 |
| 4 | 0 - 1 - 3 |

Une telle comparaison sélective permet une meilleure fiabilité qu'une comparaison globale, c'est à dire ne prenant pas en compte ces catégories. Dans le cas d'un montage direct de mesure (sonde de mesure située entre alimentation et appareil), on réalise une symétrie selon l'axe des abscisses de la forme de décharge avant comparaison : les zones 1 et 2 sont le résultat de la symétrie des zones 3 et 4 selon l'axe des abscisses et respectivement pour les zones 3 et 4 qui sont le résultat de la symétrie horizontale des zones 1 et 2.

Cette comparaison, peut se faire en utilisant n'importe quel procédé existant, par exemple : par reconnaissance de formes, assignation de vecteurs propres à certains aspects de la forme de ces décharges partielles et recherche de vecteurs correspondants, comparaison point par point... Un pourcentage de correspondance est ensuite calculé entre la forme de ces décharges partielles à identifier et les formes de décharges partielles de la catégorie correspondante. Un classement selon les pourcentages décroissants est effectué. Les formes de décharges d'un même défaut ont souvent plus de 60% de correspondance. Cependant, au vu de la complexité des forme de décharges que l'on peut être amené à mesurer, il peut y avoir des défauts différents avec un pourcentage de correspondance de forme de décharges lui aussi plus élevé que 60%. Un oeil humain pouvant assimiler une correspondance cohérente et une correspondance incohérente, cette comparaison a pour but de faciliter la présélection et de rendre celle-ci la plus proche possible de la réalité.

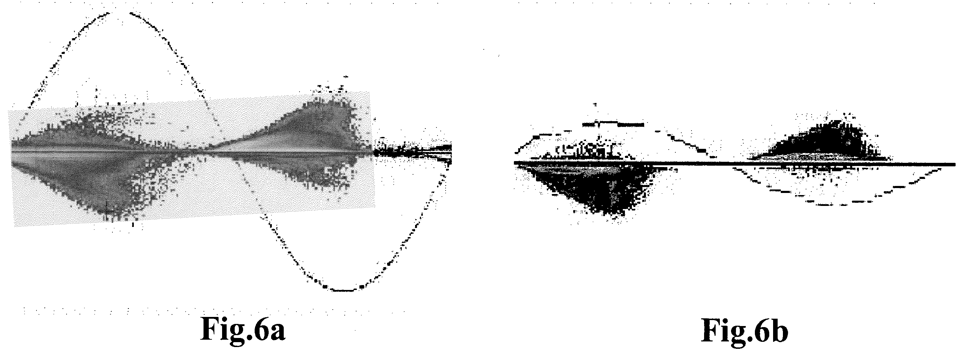

La base de donnée peut être conséquente : plusieurs centaines voire milliers de cas selon l'expérience. Une fois la correspondance trouvée et l'appareil réparé, la base de données est enrichie du retour d'expérience sur le défaut qui a provoqué les décharges partielles. Par exemple, lorsque l'on cherche à comparer la forme des décharges partielles de la figure 6a à plus de 100 autres forme de décharges dans une base de données, la forme des décharges partielles de la figure 6b arrive dans les cinq meilleurs résultats, bien que les zones 1 et 4 soient presque vides de décharges dans la figure 6b, contrairement à la figure 6a.

## Revendications

1. Procédé évolutif de reconnaissance de décharges partielles émises à l'intérieur ou à l'extérieur d'un appareil électrique, dans lequel cette reconnaissance de décharges partielles est une reconnaissance de formes de ces décharges partielles, et dans lequel,
après enregistrement dans une base de données de formes de décharges partielles connues, associées chacune à un type de défaut qui l'a générée, et après détection d'au moins une activité de décharges partielles, ce procédé comprend les étapes suivantes :
- acquisition d'une nouvelle forme de décharges partielles (Dp);
- comparaison (9) de cette nouvelle forme de décharges partielles aux formes de décharges partielles déjà enregistrées dans la base de données (12);
- obtention, après diagnostic de la source de ces décharges partielles (11), du défaut correspondant de l'appareil électrique,
- enregistrement (14) du résultat ainsi obtenu dans la base de données (12),
**caractérisé en ce que** ce procédé comprend l'acquisition d'images couleur obtenues lors de la mesure en phase et en amplitude de séries de ces décharges partielles et le traitement et la transposition de ces images couleur en images noir et blanc,
et **en ce que**, après acquisition d'une nouvelle forme de décharges partielles (Dp), ce procédé comprend une division de la nouvelle forme de décharges partielles en quatre parties égales, avec une division en deux horizontale et une division en deux verticale et une analyse des quatre zones obtenues pour assigner une catégorie à la nouvelle forme ; la comparaison de cette nouvelle forme de décharges partielles aux formes de décharges partielles déjà enregistrées dans la base de données ayant lieu en fonction de cette catégorie.

2. Procédé selon la revendication 1 comprenant une étape de correction automatique de réglage de traitement de la nouvelle forme de décharges partielles.

3. Procédé selon la revendication 1 comprenant une étape d'uniformisation de la surface de la nouvelle forme de décharges partielles.

4. Procédé selon la revendication 1 comprenant une étape de classement de la nouvelle forme de décharges partielles dans une parmi différentes catégories, en divisant chaque forme de ces décharges partielles en différentes zones.

5. Procédé selon la revendication 1, dans lequel, lors de l'étape de comparaison, on réalise un calcul du pourcentage de correspondance entre la nouvelle forme de décharges partielles et les formes de décharges partielles déjà enregistrées dans la base de données et un classement selon des pourcentages décroissants.

6. Procédé selon la revendication 1, qui comprend les étapes suivantes :
- entrée d'une image couleur correspondant à la nouvelle forme de ces décharges partielles (1),
- traitement et transposition de l'image couleur en image noir et blanc (2),
- test d'existence d'une image restante (3),
• s'il ne reste pas d'image restante :
- ajustement des paramètres de traitement de l'image couleur et retour en entrée de la première étape (1),
• s'il reste des images restantes :
- vérification pour savoir si la taille de la forme de décharges partielles est significative (4),
• si taille non significative :
- dilatation dans l'axe des ordonnées de la forme de ces décharges partielles (6),
• si taille significative :
- division de la forme de ces décharges partielles en quatre zones d'intérêt (7),
- analyse de ces zones d'intérêt pour classer la forme de décharges partielles (8),
- comparaison de la forme de décharges partielles à des décharges partielles correspondantes dans la base de données (9),
- liste des formes de décharges partielles correspondantes (10),
- diagnostic de la source de ces décharges partielles (11),
- si le diagnostic indique une source de décharges intérieures alors examen de l'appareil électrique pour réparer celui-ci (13) et corréler le diagnostic,
- enregistrement dans la base de données des résultats ainsi obtenus (14).

## Patentansprüche

1. Erweiterbares Verfahren zum Erkennen von innerhalb oder außerhalb einer elektrischen Vorrichtung emittierten Teilentladungen, wobei es sich bei diesem Erkennen von Teilentladungen um ein Erkennen von Formen dieser Teilentladungen handelt und wobei
nach Aufzeichnung von bekannten Formen von Teilentladungen, die jeweils einer dadurch verursachten Fehlerart zugeordnet sind, in einer Datenbank und vor Detektion zumindest einer Aktivität von Teilentladungen dieses Verfahren die nachfolgenden Schritte umfasst:
- Erfassen einer neuen Form von Teilentladungen (Dp);
- Vergleichen (9) dieser neuen Form von Teilentladungen mit den bereits in der Datenbank (12) aufgezeichneten Formen von Teilentladungen;
- nach Diagnose der Quelle dieser Teilentladungen (11) Erhalt des entsprechenden Fehlers der elektrischen Vorrichtung,
- Aufzeichnen (14) des so erhaltenen Ergebnisses in der Datenbank (12),
**dadurch gekennzeichnet, dass** dieses Verfahren das Erfassen von Farbbildern umfasst, die bei der Phasen- und Amplitudenmessung von Reihen dieser Teilentladungen erhalten werden, sowie das Verarbeiten und das Übertragen dieser Farbbilder in Schwarz-/Weißbilder,
und dass nach dem Erfassen einer neuen Form von Teilentladungen (Dp) dieses Verfahren eine Unterteilung der neuen Form von Teilentladungen in vier gleiche Teile mit einer horizontalen Zweiteilung und einer vertikalen Zweiteilung und einer Analyse der vier erhaltenen Bereiche umfasst, um der neuen Form eine Kategorie zuzuweisen; wobei das Vergleichen dieser neuen Form von Teilentladungen mit den bereits in der Datenbank aufgezeichneten Formen von Teilentladungen in Abhängigkeit von dieser Kategorie erfolgt.

2. Verfahren nach Anspruch 1, umfassend einen Schritt der automatischen Korrektur der Einstellung der Verarbeitung der neuen Form von Teilentladungen.

3. Verfahren nach Anspruch 1, umfassend einen Schritt der Vereinheitlichung der Oberfläche der neuen Form von Teilentladungen.

4. Verfahren nach Anspruch 1, umfassend einen Schritt der Einstufung der neuen Form von Teilentladungen in eine von verschiedenen Kategorien, indem jede Form dieser Teilentladungen in verschiedene Bereiche unterteilt wird.

5. Verfahren nach Anspruch 1, wobei bei dem Schritt des Vergleichens eine Berechnung des Prozentsatzes an Übereinstimmung zwischen der neuen Form von Teilentladungen und den bereits in der Datenbank aufgezeichneten Formen von Teilentladungen und eine Einstufung nach absteigenden Prozentsätzen erfolgen.

6. Verfahren nach Anspruch 1, das die nachfolgenden Schritte umfasst:
- Eingeben eines Farbbilds, das der neuen Form dieser Teilentladungen (1) entspricht,
- Verarbeiten und Übertragen des Farbbilds in ein Schwarz-/Weißbild (2),
- Prüfen, ob noch ein Restbild besteht (3),
• wenn kein Restbild besteht:
- Anpassen der Parameter zum Verarbeiten des Farbbilds und Rückkehr zur Eingabe beim ersten Schritt (1),
• wenn Restbilder bestehen:
- Überprüfen, ob die Größe der Form von Teilentladungen bedeutend ist (4),
• wenn die Größe unbedeutend ist:
- Erweitern der Form dieser Teilentladungen in der Ordinatenachse (6),
• wenn die Größe bedeutend ist:
- Unterteilen der Form dieser Teilentladungen in vier relevante Bereiche (7),
- Analyse dieser relevanten Bereiche zum Einstufen der Form von Teilentladungen (8),
- Vergleichen der Form von Teilentladungen mit entsprechenden Teilentladungen in der Datenbank (9),
- Verzeichnis der Formen von entsprechenden Teilentladungen (10),
- Diagnose der Quelle dieser Teilentladungen (11),
- wenn die Diagnose eine Quelle von inneren Entladungen angibt, Überprüfen der elektrischen Vorrichtung, um diese zu reparieren (13) und die Diagnose zu korrelieren,
- Aufzeichnen der so erhaltenen Ergebnisse in der Datenbank (14).

## Claims

1. A progressive method of recognizing partial discharges emitted inside or outside electrical equipment, wherein this recognition of partial discharges is shape recognition of these partial discharge patterns, and wherein
after recording known partial discharge patterns in a data base with each pattern being associated with the type of fault that generated it, and after detecting at least one partial discharge activity, said method comprises the following steps:
· acquiring a new partial discharge (Pd) pattern.
· comparing (9) said new partial discharge pattern with partial discharge patterns that are already recorded in the data base (12);
· after diagnosing the source of said partial discharges (11), obtaining the matching fault in the equipment; and
· recording (14) the result thus obtained in the data base (12).
**characterized in that** said method comprises acquiring color images obtained by measuring a series of these partial discharge patterns in phase and in amplitude and processing and transposing the color images into black and white images,
and **in that**, after acquiring a new partial discharge (Pd) pattern, said method comprises sub-dividing the new partial discharge pattern into four equal portions, splitting it in two both horizontally and vertically and analyzing said four zones to classify the new pattern in one category, comparing said new partial discharge pattern with the previously recorded partial discharge patterns in the date base in relying on said category.

2. A method according to claim 1, including an automatic correction step for adjusting processing of the new partial discharge pattern.

3. A method according to claim 1, including a step of making the surface area of the new partial discharge pattern uniform.

4. A method according to claim 1, including a step of classifying the new partial discharge pattern in one of various categories, by sub-dividing each pattern of said partial discharges into different zones.

5. A method according to claim 1, wherein during the comparison step, a match percentage calculation is performed between the new partial discharge pattern and the patterns that are already recorded in the data base, and matches are classified by decreasing percentage.

6. A method according to claim 1, including the following steps:
· entering a color image (1) corresponding to the new pattern of said partial discharges;
· processing and transposing the color image into a black and white image (2);
· testing whether an image remains (3);
• if no images remain:
· adjusting the color image processing parameters and returning to the start of the first step (1) ;
• if an image remains:
· checking to find out whether the size of the partial discharge pattern is significant (4);
• if the size is not significant:
· expanding the partial discharge pattern along the ordinate axis (6);
• if the size is significant:
· sub-dividing said partial discharge pattern into four zones of interest (7);
· analyzing said zones of interest in order to classify the partial discharge pattern (8);
· comparing the partial discharge pattern with corresponding partial discharge patterns in the data base (9) ;
· listing the matching partial discharge patterns (10);
· diagnosing the source of said partial discharge (11);
· if diagnosis indicates an inside source of discharge then examining the equipment in order to repair said equipment (13) and correlating the diagnosis; and
· recording the results thus obtained (14) in the data base.
